# EUROPÄISCHE PATENTSCHRIFT

(11) **EP 1 273 043 B1**
(45) Veröffentlichungstag und Bekanntmachung des Hinweises auf die Patenterteilung: **22.06.2011**
(21) Anmeldenummer: 01927619.5
(22) Anmeldetag: 24.03.2001
(51) Int. Cl.: H01L 29/78, H01L 29/10, H01L 21/336

(54) **CMOS-KOMPATIBLER LATERALER DMOS-TRANSISTOR**
CMOS-COMPATIBLE LATERAL DMOS TRANSISTOR
TRANSISTOR DMOS LATERAL COMPATIBLE CMOS

(30) Priorität: 31.03.2000 DE 10004387; 18.12.2000 DE 10063135
(43) Veröffentlichungstag der Anmeldung: 08.01.2003
(73) Patentinhaber: IHP GmbH-Innovations for High Performance Microelectronics / Leibniz-Institut für innovative Mikroelektronik, 15236 Frankfurt / Oder (DE)
(72) Erfinder: EHWALD, Karl-Ernst, D-15234 Frankfurt (Oder) (DE); HEINEMANN, Bernd, 15234 Frankfurt (Oder) (DE); KNOLL, Dieter, 15230 Frankfurt (Oder) (DE); WINKLER, Wolfgang, 15234 Frankfurt (Oder) (DE)
(74) Vertreter: Eisenführ, Speiser & Partner
(86) Internationale Anmeldenummer: PCT/DE2001/001175
(87) Internationale Veröffentlichungsnummer: WO 2001/075979

(56) Entgegenhaltungen:
- US-A- 5 883 413
- US-A- 5 994 189
- ISAO YOSHIDA ET AL: "HIGHLY EFFICIENT UHG-BAND SI POWER MOSFET FOR RF POWER AMPLIFIERS" ELECTRONICS & COMMUNICATIONS IN JAPAN, PART II - ELECTRONICS,US,SCRIPTA TECHNICA. NEW YORK, Bd. 77, Nr. 4, 1. April 1994 (1994-04-01), Seiten 10-19, XP000485748 ISSN: 8756-663X
- J.A.APPELS ET AL.: "High Voltage Thin Layer Devices (Resurf Devices)" INTERNATIONAL ELECTRON DEVICES MEETING, 3. Dezember 1979 (1979-12-03), Seiten 238-241, XP002157835 Washington, USA
- PATENT ABSTRACTS OF JAPAN vol. 1999, no. 03, 31. März 1999 (1999-03-31) -& JP 10 321842 A (TOSHIBA MICROELECTRON CORP;TOSHIBA CORP), 4. Dezember 1998 (1998-12-04)
- LUDIKHUIZE A W: "Kirk effect limitations in high voltage IC's" PROCEEDINGS OF THE 6TH INTERNAT. SYMPOSIUM ON POWER SEMICONDUCTOR DEVICES & IC'S, Seiten 249-252, Davos, Switzerland
- KATSUEDA M ET AL: "UHF band high-power MOSFET" ELECTRONICS AND COMMUNICATIONS IN JAPAN, PART 2 (ELECTRONICS), Bd. 73, Nr. 8, August 1998 (1998-08), Seiten 79-87, XP000179017

## Beschreibung

Die Erfindung betrifft einen CMOS-kompatiblen lateralen DMOS-Transistor und Verfahren zur Herstellung eines derartigen Transistors.

Es sind eine Vielzahl von lateralen DMOS-Transistorkonstruktionen sowohl für den Einsatz als Hochspannungsbauelement mit mehr als 100 V Drainspannung, als auch für die Hochfrequenzleistungsverstärkung bei mittleren Betriebspannungen, z. B. im Bereich zwischen 10 V und 20 V bekannt. Ein bekannter Typ von LDMOS-Konstruktionen verwendet einen abgestuften Gateisolator zur Reduzierung der Feldstärke an der drainseitigen Kante des Steuergates. Ein Beispiel sind die besonders für hohe Drainspannungen geeigneten sogenannten Fieldgap oder Thick-Field-Drift Region Anordnungen, beispielsweise beschrieben in I.Yoshida u. a., IEDM Tech. Dig. 1997, p. 51-53 sowie in T. R. Efland u. a., IEDM Tech. Dig. 1998, p. 679-682. Letztere Konstruktion ist aber bei typischen Feldoxiddicken von ca. 0,5 µm nicht ohne weiteres skalierbar für sehr hohe Grenzfrequenzen (Länge des Driftgebietes < 0,5 µm für fₜ > 20 GHz) und nur bedingt kompatibel mit einer standardmäßigen CMOS-Technologie.

Insbesondere ist trotz zusätzlicher Lackmaske für eine LDD-Implantation unter dem Feldgebiet bei modernen Isolationstechniken, z. B. bei der sogenannten "Shallow Trench"-Technologie, die Dotierung der Randbereiche des Feldgebietes problematisch.

Andere Konstruktionen verwenden anstelle des normalen dünnen Gate-Dielektrikums der Standardtransistoren einen gesondert erzeugten dickeren Gateisolator für die DMOS-Strukturen im gesamten Steuergatebereich oder in einem Teil desselben, vgl. T. R. Efland u. a., IEDM Tech. Dig. 1998, p. 679-682, was ebenfalls mit einem erheblichen Zusatzaufwand verbunden ist und im ersteren Falle zusätzlich die Sättigungssteilheit der Transistoren verringert. Weitere bekannte Konstruktionen (sogenannte Activgap oder Low Voltage Planar Anordnungen, wie in I. Yoshida u.a., IEDM Tech. Dig. 1997, p. 51-53 und T. R. Efland u. a., IEDM Tech. Dig. 1998, p.679-682 beschrieben, vermeiden die oben genannten technologischen Nachteile, indem sie im Wesentlichen nur den standardmäßigen CMOS-Prozess zu ihrer Herstellung benötigen, erreichen aber keinen optimalen Kompromiss zwischen der Drain-Durchbruchspannung, dem On-Widerstand (Rₒₙ) und der Grenzfrequenz. Insbesondere ist die Gewährleistung einer ausreichenden Langzeitstabilität infolge verstärkter Heißelektroneneffekte durch zu hohe Feldstärken an der drainseitigen Gatekante erschwert.

Kürzlich wurde vorgeschlagen, die Dotierung des LDD-Gebiets im Driftraum durch einen sogenannten Splitt-LDD-Prozess abzustufen und dabei die LDD-Dotierung in Nähe der Gatekante soweit zu verringern, dass in diesem Bereich bei hinreichender Drainspannung eine vollständige Verarmung an freien Ladungsträgern erreicht wird und dadurch die Heißelektroneneffekte und die Drain/Gate Kapazität reduziert werden, vgl. S. Xu u. a., IEDM Tech. Dig. 1999, p. 201-204. Bei diesem Vorschlag ist jedoch in jedem Falle eine zusätzliche Lackmaske im Vergleich zum CMOS-Standardprozess erforderlich. Trotz dieser Maßnahme ist der On-Widerstand Rₒₙ durch die notwendigerweise extrem geringe LDD-Dotierung in Gatenähe verhältnismäßig hoch und eine gleichzeitige Realisierung von optimierten HF-DMOS-Transistoren zusammen mit DMOS-Transistoren für sehr hohe Draindurchbruchspannungen (>100V) und niedrigem On-Widerstand Rₒₙ ist infolge der höheren drainseitigen Dotierung des nicht verarmbaren LDD-Bereiches nicht möglich.

Ein LDMOS-Transistor mit einem Gate isolator einheitlicher Dicke unter einem strom durch flossenen, aktiven Bereich des Steuergates und mit einem Wellbereich, der eine die Transistorschwellspannung bestimmende oberflächennahe zone mit erhöhter Dotierungskonzentration bildet, ist aus dem Dokument US 5,883,413 bekannt. Nachteilig sing vor allem kritische Instagetoleranzen zwischen Gate une besagter oberflächennaher zone. Zusätzlich ist ein hochleistung MOSFET auch aus Katsneda u.a., Electronies and Communication in Japan, 1990, p. 79-87, bekannt.

Aufgabe der Erfindung ist es, die oben genannten Nachteile des Standes der Technik zu beseitigen und einen CMOS-kompatiblen DMOS-Transistor und Verfahren zur Herstellung eines derartigen Transistors vorzuschlagen, der durch eine geeignete. Layoutgestaltung wahlweise für sehr hohe Drainspannungen oder für die Leistungsverstärkung bei sehr hohen Frequenzen ausgelegt werden kann und der mit geringem Zusatzaufwand im Vergleich zu einer üblichen sub-µm-Fertigungstechnologie für CMOS-Schaltkreise herstellbar ist. Gleichzeitig soll, ohne dass der Fertigungsaufwand erhöht wird, für eine gegebene Durchbruchspannung das Produkt aus On-Widerstand Rₒₙ und Drain-Gate Kapazität verringert werden. Diese Aufgabe wird durch die Merkmale des Hauptanspruchs und der nebengeordneten Ansprüche gelöst.

In der erfindungsgemäßen Transistorkonstruktion nimmt die die Schwellspannung bestimmende oberflächennahe Zone mit erhöhter Dotierungskonzentration (der sogenannte Wellbereich) die gesamte aktive Fläche unter dem Steuergate und zusätzlich mindestens einen Teil des Driftraumes zwischen dem Steuergate und dem hochdotierten Draingebiet ein. In diesem Driftraum zwischen Steuergate und Drain wird eine relativ zum hochdotierten Draingebiet niedrig dotierte Halbleiterzone des gleichen Leitungstyps (VLDD-Gebiet) selbstjustierend zur drainseitigen Kante des Steuergates erzeugt. Dabei wird die Nettodotierung dieses VLDD-Gebietes so gering (< 5x10¹² Dotierungsatome pro cm²) gewählt, dass dieses Gebiet mindestens in dem an das Steuergate angrenzenden, mit der Welldotierung versehenen Bereich des Driftraumes bei einer Drainspannung unterhalb der Durchbruchspannung des dünnen Gateisolators total an freien Ladungsträgern verarmt, wenn das Steuergate gesperrt ist. Dadurch wird bewirkt, dass das Halbleiterpotential in Nähe der Gatekante einer weiteren Erhöhung der Drainspannung nicht bzw. nur mit wesentlich verringertem Anstieg folgt und selbst in einem extrem dünnen Gateisolator auch bei einer hohen Drainspannung keine unzulässig hohe elektrische Feldstärke auftritt. Durch Optimierung des vertikalen Dotierungsprofils. außerhalb des Wellbereiches und der VLDD-Dotierung kann erreicht werden, dass an der Grenze des Wellbereiches innerhalb des Driftraumes ein lateraler Potentialabfall in Richtung auf das Steuergate entsteht, welcher die gewöhnlich an der Drain- und Gatekante auftretenden Feldstärkemaxima reduziert. Im Vergleich zu der von S. Xu u. a. beschriebenen Lösung muss die VLDD-Dotierung in Nähe der Gatekante wegen der dort vorhandenen, den Driftraum überlappenden höheren Welldotierung nicht reduziert werden, sondern kann mit Rücksicht auf Rₒₙ sogar deutlich höher eingestellt werden, als im übrigen Teil des Driftraumes, obwohl das Potential bei totaler Verarmung dieses Bereiches sehr niedrig gehalten werden kann, z. B. 2 V. Dadurch wird, ohne dass andere Nachteile auftreten, der On-Widerstand Rₒₙ im Vergleich zu den bisher bekannten Lösungen verringert. Ein weiterer Vorteil dieser Konstruktion mit einem mindestens im Wellbereich bereits bei kleiner Drainspannung total verarmten VLDD-Gebiet liegt darin, dass bei RF-DMOS-Strukturen mit sehr geringer Kanallänge das Fenster der Lackmaske für die Sourceimplantation nicht auf dem Steuergate enden muss, sondern den Driftraum überlappen darf. In diesem Falle bildet sich bei der Source/Drain-Implantation zwischen dem Steuergate und dem Driftraum ein floatendes, schmales, hochdotiertes Gebiet aus, dessen Potential durch die vorgeschaltete total verarmte VLDD-Zone auch bei hohen Drainspannungen auf einen Wert unterhalb der Durchbruchspannung des Gateisolators begrenzt wird. Durch die Länge des Driftraumes und die Position der Grenze des Wellbereiches innerhalb des Driftraumes kann die Durchbruchspannung und das Hochfrequenzverhalten des DMOS-Transistors den jeweiligen Schaltungsanforderungen optimal angepasst werden. Die Herstellung des CMOS-kompatiblen DMOS-Transistors kann zweckmäßigerweise so erfolgen, dass der Gateisolator, das Steuergate, der Wellbereich, die Source- und Draingebiete sowie alle Kontakte und Leitbahnen gleichzeitig mit den entsprechenden Teilgebieten der normalen Schaltungstransistoren ohne irgendeinen zusätzlichen technologischen Aufwand erzeugt werden. Das VLDD-Gebiet kann hierbei im einfachsten Falle durch eine maskenlose Zusatzimplantation, die z. B. nach der Strukturierung der Steuergates der MOS-Transistoren erfolgt, erzeugt werden, oder das VLDD-Gebiet wird durch eine zusätzliche, im normalen CMOS-Prozess nicht benötigte Lackmaske implantiert, oder die Dotierung dieses Gebietes erfolgt durch die Kombination einer großflächigen Ionenimplantation mit einer Implantation durch eine zusätzliche Lackmaske. In letzterem Falle kann eine im Ausführungsbeispiel beschriebene, besonders günstige, dreifach abgestufte Potentialverteilung im Driftraum erzielt werden.

In einem weiteren Beispiel der DMOS-Transistorkonstruktion wird eine in der ersten Leitbahnebene über dem an das Steuergate anschließenden Teil des Driftraumes angeordnete und mit dem Gate oder Source des DMOS-Transistors verbundene Feldplatte dazu benutzt, das Halbleiterpotential in dem unter der Feldplatte liegenden Teil des Driftraumes gegen eventuelle statische Aufladungen der Isolatoroberfläche abzuschirmen.

In einer weiteren Ausgestaltung wird eine zweite Feldplatte, welche mit einem im Driftraum floatend angeordneten Draingebiet verbunden ist, über dem an das hochdotierte Draingebiet anschließenden Teil des Driftraumes angebracht. Diese zweite Feldplatte wird vorzugsweise aus dem Metall der obersten oder einer höherliegenden Leitbahnebene gebildet und kann in Abhängigkeit von der gewünschten Durchbruchspannung mit der ersten Feldplatte einen Überlappungsbereich ausbilden oder nur einen Teil des freiliegenden Driftraumes in Nähe des hochdotierten Draingebietes bedecken.

Für Anwendungen mit Durchbruchspannungen > 200 V können die genannten Feldplatten durch mehrere voneinander isolierte, ringförmig um die Drainelektrode angeordnete Metallstreifen ersetzt werden, welche jeweils mit einem kleinen hochdotierten Gebiet vom Leitungstyp des Draingebietes verbunden sind. Die genannten kleinen floatenden hochdotierten Gebiete werden dabei grundsätzlich im außerhalb des Wellgebietes gelegenen Teil des Driftraums angeordnet und dienen zur Fixierung eines für eine gleichmäßige Feldverteilung im Driftraum richtig abgestuften Potentials auf den oben genannten ringförmigen Metallstreifen und auf der Halbleiteroberfläche.

Eine weitere günstige Ausgestaltung der Erfindung für hohe Durchbruchspannungen erzielt eine gleichmäßigere Feldverteilung im Übergangsbereich zwischen dem Wellgebiet und dem schwächer dotierten Teil des Driftraumes durch eine spezielle Gestaltung der Schablone, mit welcher die Resistmaske für die Implantation des Wellgebietes erzeugt wird. Dabei werden in Nähe der im Driftraum gelegenen lateralen Wellgrenze sehr kleine Einschnitte, Perforationen oder Unterbrechungen in der Resistmaske erzeugt, welche in ihren Abmessungen kleiner als oder vergleichbar mit der vertikalen Eindringtiefe des Weltbereiches im fertigen Bauelement sind. Dadurch wird der laterale Dotierungsgradient am Rande des Wellgebietes ebenfalls verringert. Vor allem bei der Verwendung sehr hochohmiger Substrate kann es zur Einstellung einer optimalen Potentialverteilung im Driftraum zweckmäßig sein, bei der maskenlosen oder über eine Lackmaske durchgeführten Implantation der VLDD-Gebiete auch außerhalb des Wellbereiches zusätzlich ein Dotierelement vom Leitungstyp des Wellbereiches zu implantieren. Bei Bedarf kann hierfür auch eine gesonderte Lackmaske verwendet werden. Die Implantationsenergie wird dabei so gewählt, dass die Eindringtiefe deutlich größer ist, als diejenige der eigentlichen VLDD Implantation, dass aber wenigstens der größte Teil dieser Zusatzdotierung bei totaler Verarmung des VLDD-Gebietes im Raumladungsbereich liegt. Die Flächendosis dieser Zusatzdotierung vom Leitungstyp des Wellbereiches ist kleiner oder gleich der Nettodosis im darüber liegenden VLDD-Gebiet. Mit dieser Maßanhme wird es bei vorgegebenem Maximalpotential im VLDD-Gebiet (bei totaler Verarmung desselben) möglich, die Nettodotierung des VLDD-Gebietes im Driftbereich außerhalb des p-Wellbereiches zu erhöhen und damit Rₒₙ entsprechend zu senken. Die Merkmale der Erfindung gehen außer aus den Ansprüchen auch aus der Beschreibung, den Ausführungsbeispielen und der Zeichnung hervor, wobei die einzelnen Merkmale jeweils für sich allein oder zu mehreren in Form von Unterkombinationen schutzfähige Ausführungen darstellen, für die hier Schutz beansprucht wird. In mehreren Ausführungsbeispielen wird die Erfindung im Folgenden näher erläutert. Die zugehörige Zeichnung zeigt schematisch den Aufbau eines erfindungsgemäßen CMOS-kompatiblen lateralen DMOS-Transistors.

### Beispiel 1

Auf Si-Scheiben mit einem p-Substrat **1** und einer schwach dotierten Epitaxieschicht **2** werden mit standardmäßigen CMOS-Prozesschritten zunächst die Feldoxidgebiete **3,** die p-Wellgebiete **4,** das Gateoxid **5** und die Poly-Si-Gebiete **6** erzeugt. Anschließend werden durch die Fenster einer im normalen CMOS-Prozess nicht vorkommenden Lackmaske die VLDD-Gebiete **7** und **7a** vor der Herstellung der Gatespacer **8** durch eine As-Implantation geringer Energie und mit einer Dosis < 10¹³/cm² realisiert. Danach wird der CMOS-Standardprozess mit der Herstellung der Gatespacer **8,** der Implantation der n⁺-Gebiete **9, 9a, 9b** und **9c** sowie der p⁺-Gebiete **10** fortgesetzt.

Zwischen dem Steuergate **6** und dem VLDD-Gebiet **7** befindet sich ein floatendes hochdotiertes Pseudodraingebiet **9b** vom Leitungstyp des hochdotierten Draingebietes **9,** welches sich unmittelbar an das Steuergate **6** anschließt und dessen maximales Potential von dem bereits bei Drainspannungen unterhalb der Gatedurchbruchspannung total verarmten Bereich **7** des VLDD-Gebietes kontrolliert wird.

Als weiterer nicht im Standardablauf enthaltener Prozess folgt eine unmaskierte P-Implantation zur Herstellung der schwächer dotierten VLDD-Gebiete **11.** Danach ist die gesamte Oberfläche des Driftraumes von einer im Vergleich zum hochdotierten Draingebiet **9** niedrig dotierten Zone vom Leitungstyp des Draingebietes (VLDD-Gebiete **7,11, 7a)** bedeckt, in welcher die flächenbezogene Nettodotierungskonzentration einen Wert von **5-10¹²** At/cm² nicht überschreitet. Anschließend wird der Standardprozess mit der Abscheidung und Strukturierung der Salizidblockerschicht **12,** der Salizierung der Gebiete **13,** der Abscheidung und Planarisierung der Isolatorschicht **14,** der Ätzung und Metallverfüllung der Kontaktfenster **15** und der Abscheidung und Strukturierung der ersten Aluminiumleitbahnebene weitergeführt. Der mit obenstehendem technologischen Ablauf hergestellte DMOS-Transistor, dessen Sourcegebiet 9c mit einem außenliegenden Sourceanschluss **16a** ringförmig um das im Zentrum der Struktur liegende hochdotierte Draingebiet **9** mit dem Drainkontakt **16** ausgebildet ist, besitzt zur Stabilisierung einer optimalen Feldverteilung im Driftraum zwei Metallringe **16b** und **16c,** die den Driftraum zum großen Teil bedecken. Der dem Steuergate benachbarte Metallring 16b ist mit demselben leitend verbunden und bedeckt das höherdotierte VLDD-Gebiet 7 im Wellbereich. Der zweite Metallring **16c** liegt bei anliegender maximaler Drainspannung auf einem mittleren positiven Potential, welches im Vergleich zur Drainspannung deutlich niedriger ist und über das als Potentialsonde wirkende, innerhalb des Driftraumes liegende n⁺-Gebiet **9a** eingestellt wird.

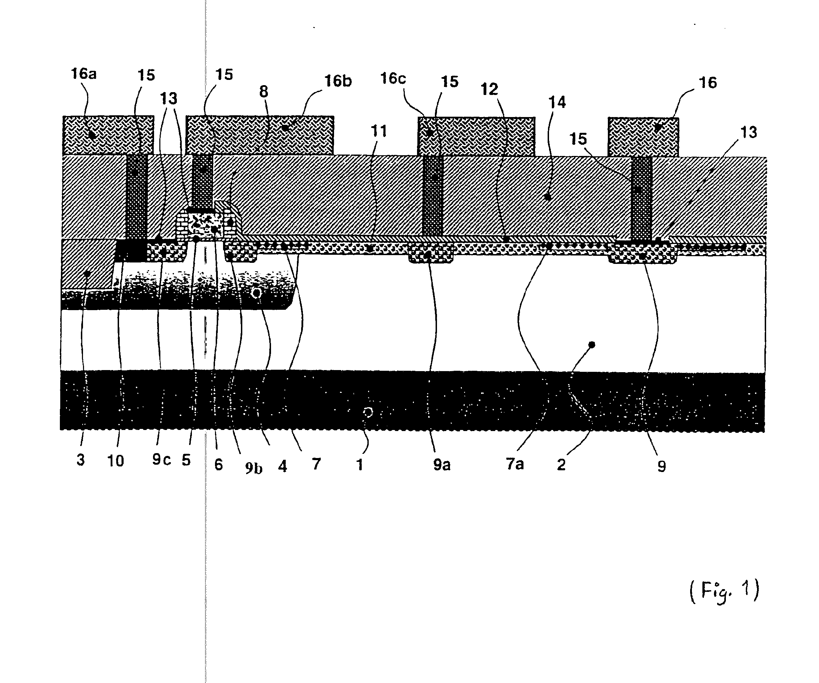

Die äußeren Kanten des Metallringes **16c** verlaufen näherungsweise parallel zu den Äquipotentiallinien der Driftraumoberfläche. Die Gebiete **16, 16a, 16b, 16c** sind Bestandteil einer oder mehrerer Leitbahnebenen des standardmäßigen Leitbahnsystems für integrierte Schaltkreise. Mit der in der Fig. 1 skizzierten Anordnung kann das Drainpotential in mehreren Stufen in Richtung auf das Steuergate treppenförmig abgebaut werden. Dabei ist die Höhe der ersten Stufe durch die zur totalen Verarmung des an das Draingebiet anschließenden höherdotierten VLDD-Gebietes **7a** erforderliche Spannung gegeben. Durch Optimierung der Lateralgeometrie des beschriebenen LDMOS-Transistors kann erreicht werden, dass bei kleinstmöglichem On-Widerstand Rₒₙ die Draindurchbruchspannung durch den vertikalen Lawinendurchbruch zwischen dem hochdotierten Draingebiet und dem Substrat bestimmt wird. Auf diese Weise ist es möglich, mit dem gleichen technologischen Ablauf schnelle MOS-Transistoren für Logikanwendungen mit niedrigen Betriebsspannungen gleichzeitig mit RF-DMOS-Leistungstransistoren für mittlere Betriebsspannungen und mit Hochspannungstransistoren für mehrere 100 V auf der gleichen Scheibe herzustellen. Der zusätzliche Fertigungsaufwand besteht dabei lediglich in einer zusätzlichen Lackmaske und einer maskierten und einer großflächig durchgeführten Ionenimplantation.

### Beispiel 2

Auf Si-Scheiben mit einem p-Substrat **1** und einer schwach dotierten Epitaxieschicht **2** mit standardmäßigen CMOS-Prozessschritten werden zunächst die Feldoxidgebiete **3**, die p-Wellgebiete **4**, das Gateoxid **5** und die Poly-Si-Gebiete **6** erzeugt, wobei die zur Maskierung der Dotierung des Wellbereiches **4** benutzte Lackmaske innerhalb des Driftraumes an der Maskenkante und/oder in der Nähe derselben mit geeignet angeordneten kleinstmöglichen Einschnitten, Perforationen oder Unterbrechungen versehen ist, wobei die Implantationsenergie und die nach der Implantation wirksame Wärmebelastung für den Wellbereich **4** so gewählt sind, dass die Eindringtiefe des Wellbereiches **4** im Gebiet des Driftraumes mit den Abmessungen besagter Einschnitte, Perforationen oder Unterbrechungen mindestens vergleichbar ist. Im Weiteren wird nach Beispiel 1 verfahren.

### Beispiel 3

In einer weiteren Ausführungsvariante wird nach der Erzeugung der Feldoxidgebiete **3**, der p-Wellgebiete **4,** des Gateoxid **5** und der Poly-Si-Gebiete **6** durch CMOS-Prozessschritte das VLDD-Gebiet ohne Maske großflächig durch eine Ionenimplantation dotiert. Im Übrigen wird nach den Beispielen 1 oder 2 verfahren.

### Beispiel 4

Nach der Erzeugung der Feldoxidgebiete **3**, der p-Wellgebiete **4**, des Gateoxides **5** und der Poly-Si-Gebiete **6** durch CMOS-Prozesschritte wird die Dotierung des VLDD-Gebiets durch die Kombination einer durch eine Lackmaske maskierten und einer großflächigen Ionenimplantation so durchgeführt, dass bei der maskierten Ionenimplantation ein an das hochdotierte Draingebiet **(9)** direkt angrenzender Teilbereich des Driftraumes abgedeckt wird. Die übrigen Verfahrensschritte werden wie in den Beispielen 1 und 2 erläutert, vollzogen.

In der vorliegenden Beschreibung wurden anhand eines konkreten Ausführungsbeispiels ein CMOS-kompatibler lateraler DMOS-Transistor und Verfahren zur Herstellung eines derartigen Transistors erläutert. Es sei aber vermerkt, dass die vorliegende Erfindung nicht auf die Einzelheiten der Beschreibung im Ausführungsbeispiel beschränkt ist, da im Rahmen der Ansprüche Änderungen und Abwandlungen beansprucht werden.

## Patentansprüche

1. CMOS-kompatibler lateraler DMOS-Transistor, umfassend:
einen Gateisolator (5) mit einer einheitlichen Dicke in einem gesamten aktiven Bereich, durch den Strom fließt, unter einem Steuergate (6);
mit einem Wellbereich, der eine die Transistorschwellspannung bestimmende oberflächennahe Zone (4) mit erhöhter Dotierungskonzentration bildet;
einem hochdotierten Draingebiet (9);
wobei mindestens ein Halbleiterbereich unmittelbar neben und unter dem hochdotierten Draingebiet (9) eine deutlich geringere Dotierungskonzentration im Vergleich zur Dotierung des Wellbereiches besitzt, und
der Wellbereich so angeordnet ist, dass er die gesamte Fläche unter dem auf dem aktiven Bereich liegenden Steuergate (9) einnimmt und innerhalb eines Drift-raumes zwischen dem Steuergate (6) und einem hochdotierten Draingebiet (9) endet, und dass
der Driftraum an seiner gesamten Oberfläche von einem VLDD-Gebiet (7, 11),
nämlich einen im Vergleich zum hochdotierten Draingebiet (9) niedrig dotierten Gebiet vom Leitungstyp des Draingebietes, bedeckt ist, in welchem eine flächenbezogene Nettodotierungskonzentration einen Wert von 5x10¹² cm⁻² nicht überschreitet und welches bei einer anliegenden Drainspannung, die unter einer Durchbruchsspannung des Gateisolators (5) liegt, mindestens in dem an das Steuergate (6) angrenzenden, im Wellbereich (4) liegenden Teil des Driftraumes oder in einem Teil des Driftraumes, der an eine unmittelbar an das Steuergate (6) anschließende hochdotierte Zone (9b) vom Leitungstyp des hochdotierten Draingebiets (9) angrenzt, bis zur Halbleiteroberfläche total an freien Ladungsträgern verarmt ist,
**dadurch gekennzeichnet, dass** die flächenbezogene Nettodotierungsmenge des VLDD-Gebietes (7) im Wellbereich (4) bis zur drainseitigen Kante des Steuergates (6) höher ist gegenüber der flächenbezogenden Nettodotierungsmenge des sich unmittelbar daran anschließenden VLDD-Gebiets (11) außerhalb des Wellbereiches (4).

2. CMOS-kompatibler lateraler DMOS-Transistor nach Anspruch 1, **dadurch gekennzeichnet, dass** die Dotierung des VLDD-Gebietes auch außerhalb des Driftraumes der DMOS-Transistoren auf allen nicht von den Steuergates **(6)** bedeckten Teilflächen der aktiven nicht von Feldoxid bedeckten Si-Gebiete vorhanden ist.

3. CMOS-kompatibler lateraler DMOS-Transistor nach Anspruch 1, **dadurch gekennzeichnet, dass** die flächenbezogene Nettodotierungsmenge des VLDD-Gebietes **(7)** im Wellbereich **(4)** bis zur drainseitigen Kante des Steuergates **(6)** und in einer an das hochdotierte Draingebiet **(9)** unmittelbar angrenzenden weiteren Zone **(7a)** des Driftraumes höher ist, als in dem übrigen Bereich des Driftraumes.

4. CMOS-kompatibler lateraler DMOS-Transistor nach Anspruch 3 **dadurch gekennzeichnet, dass** das hochdotierte Draingebiet **(9)** von einem ringförmigen Driftraum und dieser wiederum von einem ringförmigen Steuergate **(6)** umgeben ist, wobei außerhalb des an das Steuergate **(6)** anschließenden höherdotierten Teiles **(7)** des VLDD-Gebietes **(7, 11, 7a)** der Driftraum mit einem oder mehreren floatenden hochdotierten Gebiet(en) **(9a)** vom Leitungstyp des hochdotierten Draingebietes **(9)** versehen ist, wobei dieses Gebiet **(9a)** oder jedes dieser Gebiete **(9a)** seinerseits derart mit einem konzentrisch um das Draingebiet **(9)** angeordneten Metallring **(16c)** verbunden ist, dass die äußeren Kanten des Metallringes **(16c)** oder mehrerer konzentrisch angeordneter Metallringe **(16c)** näherungsweise parallel zu den Äquipotentiallinien der Driftraumoberfläche verlaufen und der oder die konzentrischen Metallringe **(16c)** dabei Bestandteil einer oder mehrerer Leitbahnebenen des standardmäßigen Leitbahnsystems für integrierte Schaltkreise sind.

5. CMOS-kompatibler lateraler DMOS-Transistor nach einem oder mehreren der Ansprüche 1 bis 4, **dadurch gekennzeichnet, dass** sich zwischen dem Steuergate (6) und dem VLDD-Gebiet **(7, 11, 7a)** ein floatendes hochdotiertes Pseudodraingebiet **(9b)** vom Leitungstyp des hochdotierten Draingebietes **(9)** befindet, welches sich unmittelbar an das Steuergate **(6)** anschließt und dessen maximales Potential von dem bei Drainspannungen unterhalb der Gatedurchbruchspannung total verarmten Bereich des VLDD-Gebietes kontrolliert wird.

## Claims

1. CMOS-compatible lateral DMOS transistor, comprising:
a gate insulator (5) having uniform thickness throughout its active region, through which current flows, under a control gate (6);
with a well region that forms a zone (4) close to the surface having an increased doping concentration, that determines the transistor threshold voltage;
a heavily doped drain region (9);
wherein at least one semiconductor region immediately adjacent to and underneath the heavily doped drain region (9) has a significantly lower doping concentration compared with the doping of the well region, and
the well region is arranged so that it occupies the entire area under the control gate (9) located on the active region and terminates within a drift space between the control gate (6) and a heavily doped drain region (9), and in that
the drift space is covered over its entire surface by a VLDD region (7, 11), namely a region of the same conduction type as the drain region, which is lightly doped by comparison with the heavily doped drain region (9), in which a net doping concentration per unit area does not exceed a value of 5x10¹² cm⁻² and which is totally depleted in free charge carriers up to the semiconductor surface, when a drain voltage is applied that is below a breakdown voltage of the gate insulator (5), at least in the part of the drift space located in the well region (4) and adjacent to the control gate (6), or in a part of the drift space that is adjacent to a heavily doped zone (9b) of the same conduction type as the heavily doped drain region (9) located immediately adjacent to the control gate (6),
**characterised in that** the net doping amount, per unit area, of the VLDD region (7) in the well region (4) up to the edge of the control gate (6) on the drain side is greater than the net doping amount, per unit area, of the VLDD region (11) immediately adjoining it outside the well region (4).

2. CMOS-compatible lateral DMOS transistor according to claim 1, **characterised in that** the doping of the VLDD region is also present outside the drift space of the DMOS transistors on all the partial surfaces of the active Si regions not covered by field oxide that are not covered by the control gates (6).

3. CMOS-compatible lateral DMOS transistor according to claim 1, **characterised in that** the net doping amount, per unit area, of the VLDD region (7) is higher in the well region (4) up to the edge of the control gate (6) on the drain side and in another zone (7a) of the drift space that is immediately adjacent to the heavily doped drain region (9), than in the remaining part of the drift space.

4. CMOS-compatible lateral DMOS transistor according to claim 3, **characterised in that** the heavily doped drain region (9) is surrounded by an annular drift space and this is in turn surrounded by an annular control gate (6), while outside the more heavily doped part (7) of the VLDD region (7, 11, 7a) adjoining the control gate (6) the drift space is provided with one or more floating heavily doped region(s) (9a) of the same conduction type as the heavily doped drain region (9), the or each region (9a) in turn being connected to a metal ring (16c) arranged concentrically around the drain region (9) such that the outer edges of the metal ring (16c) or of the plurality of concentrically arranged metal rings (16c) run approximately parallel to the equipotential lines of the drift space surface and the concentric metal ring or rings (16c) are part of one or more pcb track planes of the standard pcb track system for integrated circuits.

5. CMOS-compatible lateral DMOS transistor according to one or more of claims 1 to 4, **characterised in that** between the control gate (6) and the VLDD region (7, 11, 7a) there is a floating, heavily doped pseudo-drain region (9b) of the same conduction type as the heavily doped drain region (9), which is immediately adjacent to the control gate (6) and the maximum potential of which is controlled by the part of the VLDD region that is totally depleted in the event of drain voltages below the gate breakdown voltage.

## Revendications

1. Transistor DMOS latéral, compatible CMOS, comprenant :
un isolateur de grille (5) avec une épaisseur unitaire, dans une région globale active, à travers laquelle passe le courant, sous une grille de commande (6) ;
avec une région ondulée, formant une zone (4) proche de la surface, déterminant la tension de seuil de transistor, présentant une concentration de dopage élevée ;
une région de drain (9) fortement dopée ;
au moins une région de semi-conducteur, directement à côté et au-dessous de la région de drain (9) fortement dopée, présentant une concentration de dopage nettement plus faible par rapport au dopage de la région ondulée, et
la région ondulée est disposée de manière qu'elle occupe la surface totale sous la grille de commande (6) située sur la région active et s'achève à l'intérieur d'un espace de drift, entre la grille de commande (6) et une région de drain (9) fortement dopée, et en ce que
l'espace de drift est couvert, sur sa surface globale, par une région VLDD (7, 11), précisément une région faiblement dopée par rapport à la région de drain (9) fortement dopée, présentant le type de conduction de la région de drain, dans laquelle une concentration en dopage net, se référant à la surface, ne dépasse pas une valeur de 5x10¹² cm⁻² et qui, dans le cas où est appliquée une tension de drain inférieure à une tension de claquage de l'isolateur de grille (5), au moins dans la partie, située dans la zone ondulée (4), limitrophe à la grille de commande (6), de l'espace de drift, ou dans une partie de l'espace de drift, limitrophe à une zone (9b) fortement dopée, se raccordant directement à la grille de commande (6), présentant le type de conduction de la région de drain (9) fortement dopée, est totalement appauvrie en porteurs de charge libres, jusqu'à une surface de semi-conducteur,
**caractérisé en ce que** la quantité de dopage net, se référant à une surface, de la région VLDD (7), dans la zone ondulée (4), jusqu'à l'arête, située côté drain, de la grille de commande (6) est plus élevée que la quantité de dopage net, se référant à une surface, de la région VLDD (11), s'y raccordant directement, à l'extérieur de la zone ondulée (4).

2. Transistor DMOS latéral, compatible CMOS, selon la revendication 1, **caractérisé en ce que** le dopage de la région VLDD est présent également à l'extérieur de l'espace de drift des transistors DMOS, sur toutes les surfaces partielles non couvertes par les grilles de commande (6), des régions en Si actives, non couvertes par l'oxyde de champ.

3. Transistor DMOS latéral, compatible CMOS, selon la revendication 1, **caractérisé en ce que** la quantité de dopage net, se référant à une surface, de la région VLDD (7), dans la zone ondulée (4), jusqu'à l'arête, située côté drain, de la grille de commande (6) et dans une autre zone (7a), directement limitrophe à la région de drain (9) fortement dopée, de l'espace de drift, est plus élevée que dans la zone restante de l'espace de drift.

4. Transistor DMOS latéral, compatible CMOS, selon la revendication 3, **caractérisé en ce que** la région de drain (9) fortement dopée est entourée par une espace de drift en forme d'anneau et celui-ci, à son tour, par une grille de commande (6) en forme d'anneau, sachant que, à l'extérieur de la partie (7) plus fortement dopée, se raccordant à la grille de commande (6), de la région VLDD (7, 11, 11a), l'espace de drift est muni d'une ou plusieurs régions (9a) fortement dopées, flottantes, présentant le type de conduction de la région de drain (9) fortement dopée, cette région (9a), ou chacune de ces régions (9a) de leur côté étant reliée à une bague métallique (16c) disposée concentriquement autour de la région de drain (9), **en ce que** les arêtes extérieures de la bague métallique (16c), ou de plusieurs bagues métalliques (16c) disposées concentriquement, s'étendant à peu près parallèlement aux lignes équipotentielles de la surface d'espace de drift, et la ou les bagues métalliques (16c) concentriques font alors partie d'un ou plusieurs plans de pistes conductrices du système de pistes conductrices standard pour des circuits intégrés.

5. Transistor DMOS latéral, compatible CMOS, selon l'une ou plusieurs des revendications 1 à 4, **caractérisé en ce que**, entre la grille de commande (6) et la région VLDD (7, 11, 11a), se trouve une peudo-région de drain (9b) fortement dopée, flottante, du type de conduction de la région de drain (9) fortement dopée, se raccordant directement à la grille de commande (6) et dont le potentiel maximal est commandé par la région, totalement appauvrie en cas de tensions de drain inférieures à la tension de claquage de grille, de la région VLDD.
